# EUROPEAN PATENT SPECIFICATION

(11) **EP 0 524 729 B1**
(45) Date of publication and mention of the grant of the patent: **01.10.1997**
(21) Application number: 92305852.3
(22) Date of filing: 25.06.1992
(51) Int. Cl.: B01D 53/50, B01D 53/74

(54) **Apparatus and methods for flue gas desulphurisation**
Vorrichtung und Verfahren zur Rauchgasentschwefelung
Appareil et méthodes de désulfuration de gaz de fumées

(30) Priority: 26.07.1991 US 736334
(43) Date of publication of application: 27.01.1993
(73) Proprietor: THE BABCOCK & WILCOX COMPANY, New Orleans, Louisiana 70160 (US)
(72) Inventor: Johnson, Dennis Wayne, Barberton, Ohio 44203 (US); Lieb, Paul James, Norton, Ohio 44203 (US)
(74) Representative: Pilch, Adam John Michael

(56) References cited:
- EP-A- 0 090 132
- EP-A- 0 363 009
- US-A- 1 722 466
- US-A- 4 263 021
- US-A- 4 315 872
- US-A- 4 776 989

## Description

This invention relates to flue gas desulphurisation, and more particularly to apparatus and methods for this purpose.

Flue gas desulphurisation (FGD) occurs primarily in flue gas absorber towers by means of spraying the flue gas with a mixture which causes the sulphur to precipitate out. This spraying is accomplished by installing spray headers across the tower opening directly in the flue gas path. In early systems which were typically comparatively small, a single spray level was all that was needed because of the low flue gas flow rates. However, as systems became larger, the flue gas flow rates increased and the spray volume was increased up to pump capacity until additional spray levels were required.

The addition of further spray levels involves the disadvantage that each level increases the absorber tower height by up to 1.5 m (5 ft) or more and this can be critical in closely confined quarters. However, despite this difficulty, the ultimate need is dictated by the flue gas flow rate and the desire to remove as much sulphur as possible before releasing these gases to the atmosphere. Thus, it has become quite common for a FGD system to incorporate five or more spray levels to accommodate the flue gas volume and sulphur density. Unfortunately, however, this has caused the absorber tower to be raised in height by about 6 m (20 ft) or more with these multiple spray levels requiring a corresponding increase in pumping and piping requirements. Thus, to accommodate greater flue gas capacity, the tower height (as well as diameter) had to be increased which required more pumping power.

In addition to these multiple spray levels, there is also a need in some systems for a spare spray level which is to be utilised when one of the other levels is out of commission or being repaired. This further adds to the cost and height of the absorber tower.

In some cases, the FGD system incorporates a high liquid to gas (L/G) ratio as compared to the more common use of low ratios in other systems. The L/G ratio is a reference to liquid flow rate relative to gas volume whose units are gallon per minute per 1000 actual cubic feet per minute (gpm/macfm), each such unit being equivalent to 1.34 x 10⁻⁴ cubic metres per minute/cubic metres per minute. This L/G ratio is determined by a number of process variables including reagent type, pH, solids particle size, reactivity, chloride ion concentration, sulphur dioxide concentration, sulphur dioxide removal, reagent utilisation, spray drop size, and the like. A high L/G ratio implies a high liquid flow rate relative to gas volume which is typically a value of 40 to 140 or more. Consequently, a low L/G ratio would generally be a value of less than 20. One way of accomplishing a high L/G ratio is by simply adding more spray levels to the absorber tower so that more of the mixture can be sprayed on to the flue gas. This, however, does not eliminate the need for a taller tower nor does it diminish the need for more pumping power so that the mixture can be delivered at the higher elevation.

Since increasing the absorber tower height is costly, and since each unit of energy needed to deliver the mixture to its assigned elevation must be paid for, it is desirable both to cut the absorber tower height and to reduce the energy requirements on each FGD system installed.

European Patent Application EP-A-0 090 132 discloses various configurations of headers and feeder lines at a spray level in an absorber tower. At least three headers extend into the flue gas path, with a number of feeder lines attached for each header. Each header and its associated feeder lines cover a distinct zone of the flue gas path.

According to one aspect of the invention there is provided flue gas desulphurisation apparatus comprising:
a flue gas desulphurisation absorber tower;
at least two elongate headers for supplying a liquid absorbent for the flue gas to the tower;
a plurality of elongate feeder lines secured to each header and extending within the tower across the flue gas flow path therethrough in at least substantially the same plane; and
a plurality of nozzles secured to each feeder line, the nozzles being configured so as to spray the liquid absorbent on to the flue gas within the tower;
   characterised in that the feeder lines from the headers are mutually staggered so as to extend in alternating interleaved manner across the flue gas path whereby adjacent feeder lines in the substantially same plane are supplied by different headers.

According to another aspect of the invention there is provided a method of spraying flue gas with a liquid absorbent in a flue gas desulphurisation absorber tower, the method comprising the steps of:
securing at least two elongate headers to the tower for supplying the liquid absorbent;
attaching multiple elongate feeder lines to each header, the feeder lines from each header extending across the flue gas flow path in at least substantially the same plane within the tower;
securing a series of nozzles to each feeder line within the tower; and
spraying the liquid absorbent through the nozzles on to the flue gas;
   characterised in that the feeder lines from the headers are mutually staggered so as to extend in alternating interleaved manner across the flue gas path whereby the liquid absorbent in adjacent feeder lines in the substantially same plane is supplied by different headers.

A preferred embodiment of this invention provides a spray level for a flue gas desulphurisation absorber tower, comprising one or more headers secured adjacent the tower, a plurality of elongate feeder lines secured to each of the headers with the feeder lines from each header being staggered with respect to each other so as to extend alternately across the flue gas flow path, the feeder lines also extending in the same, or nearly the same, plane within the tower, and multiple nozzles secured to each of the feeder lines, the nozzles being configured to spray on to the flue gas within the tower.

Embodiments of this invention provide a system that both reduces absorber tower height and lowers energy costs; the preferred FGD system can incorporate a spare spray without also increasing absorber tower height.

The invention will now be described by way of example with reference to the accompanying drawings, throughout which like parts are referred to by like references, and in which:
Figure 1 is a view, partially broken away, of a typical flue gas absorber tower illustrating the multiple spray levels normally incorporated therein;
Figure 2 is a view, partially broken away, of a flue gas absorber tower embodying the invention, the absorber tower having a single spray level;
Figure 3 is a plan view, partially broken away, of one arrangement of the single spray level;
Figures 4A to 4C are sectional views, partially broken away and taken along lines 4-4 of Figure 3, which illustrate various possible locations for the headers;
Figure 5 is a sectional view, partially broken away, taken along lines 5-5 of Figure 3;
Figures 6A to 6E are schematic diagrams of various arrangements of nozzle that can be incorporated into the spray level;
Figure 7 is a plan view, partially broken away, of an alternative embodiment of a single spray level having only two headers; and
Figure 8 is a plan view, partially broken away, of another alternative embodiment of a single spray level having only two headers.

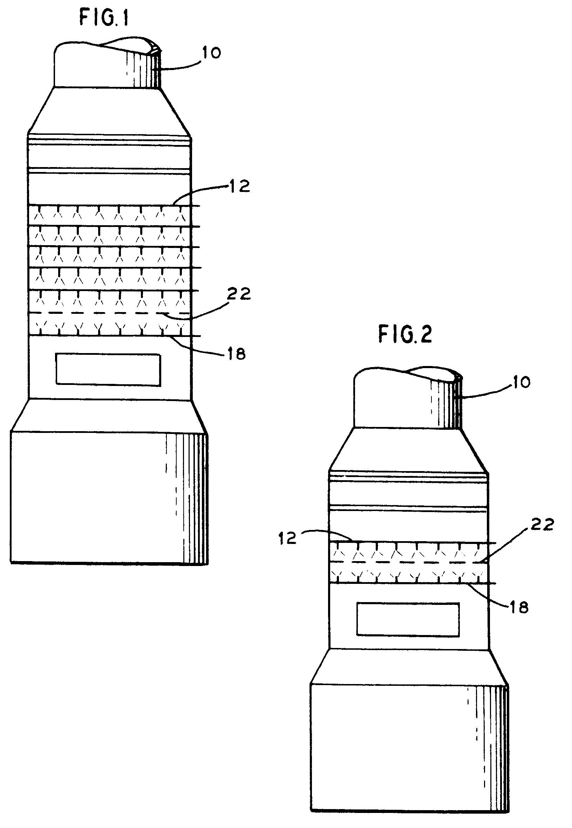

Referring initially to Figure 1, there is shown a typical absorber tower 10 for a 500 MW flue gas desulphurisation system. This typical tower extends about 36.9 m (121 ft) above the ground and is about 18.3 m (60 ft) in diameter. It encloses multiple spray levels 12 with each such level 12 usually being a duplicate of the one above and below it and with about 1.5 m (5 ft) of space between each level.

In this typical arrangement, the multiple levels 12 were needed so that the entire area of the absorber tower 10 could be covered by the spray and so that the liquid to gas flow rate (L/G) necessary to cause the desired sulphur dioxide capture could be delivered by independent large capacity pumps. It is this spray that causes the sulphur in the flue gas to fall out, thus the requirement that the spray be in contact with all of the flue gas for the system to work.

In contrast to this typical structure, Figure 2 shows an embodiment of the present invention which only requires a single spray level 12 for operation. The single spray level 12 requires a structure that is also about 18.3 m (60 ft) in diameter but which extends only about 29.6 m (97 ft) above the ground, representing a saving of about 7.3 m (24 ft) in absorber tower height. Furthermore, as will be described, the design of this embodiment can still accomplish the objective of spraying the entire flue gas for sulphur removal whilst also incorporating spare spray capacity should this be needed.

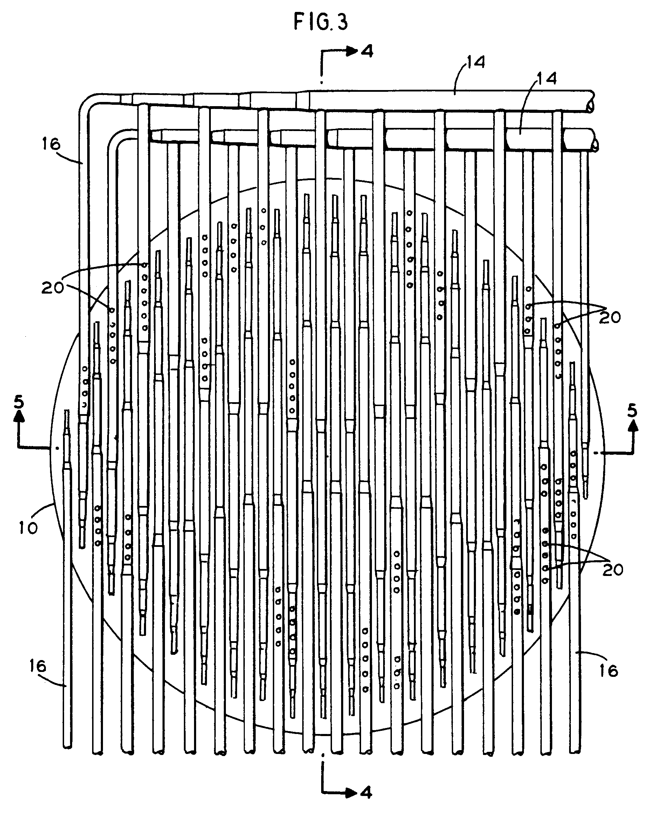

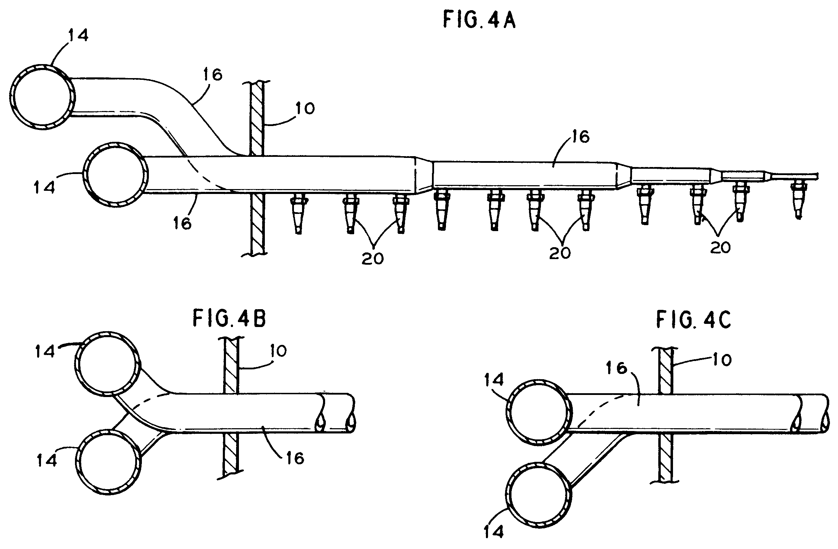

Turning now to Figures 3 to 5, it is disclosed how this reduction in absorber tower height is accomplished. In this embodiment, the single spray level 12 consists of four separate external elongate headers 14 each having a number of parallel feeder lines 16 connected thereto, the feeder lines 16 having nozzles 20 (only some of which are shown in Figure 3). These individual feeder lines 16 are reduced or become smaller in diameter the further they extend from their respective header 14 (see Figure 4). This reduction is to compensate for the drop in fluid flow that occurs in each feeder line 16 as it extends across the absorber tower 10. The purpose here is to maintain as constant a pressure as possible along the length of each feeder line 16 and to maintain reasonable line velocities. Also, it should be noted that each header 14 becomes smaller in diameter along its length for similar reasons.

As indicated, this embodiment encompasses two headers 14 on each of the opposite sides of the absorber tower 10, there accordingly being a total of four such headers 14 in this embodiment. The opposite sides of the arrangement are essentially mirror images (basically the same but rotated through 180 degrees) of each other. Each header pair on the same side of the absorber tower 10 is vertically, and in certain embodiments horizontally, spaced a slight distance from the other. This is so that the feeder lines 16 from that side (and preferably from both sides) will extend in the same plane within the absorber tower 10.

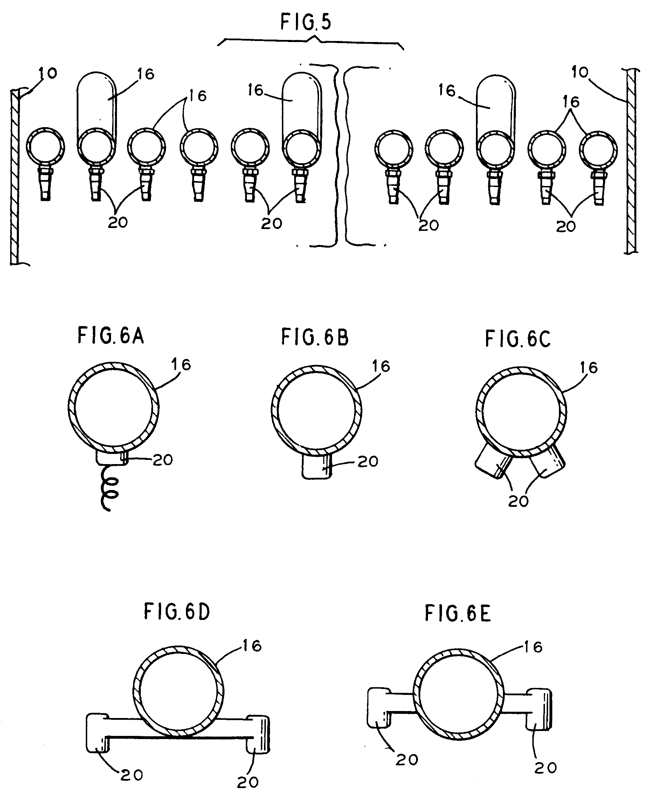

In Figure 4A, a lower header 14 lies in the desired plane whilst an upper header 14 is both horizontally and vertically offset from the lower header 14. This requires the feeder lines 16 of the upper header 14 to incorporate fittings therein so that those feeder lines 16 will lie in the same plane as the feeder lines 16 from the lower header 14. In Figure 4B, the plane of the feeder lines 16 lies between both the headers 14 thereby requiring each feeder line to be oriented accordingly. In Figure 4C, it is the upper header which lies in the plane of the feeder lines 16. In any event, no matter how the headers 14 are oriented, the feeder lines 16 are constructed to extend within the same plane (be coplanar) within the absorber tower 10 as shown in Figure 5. The design of the FGD system will determine the number of pumps and headers 14 required. The combination shown is for two headers 14 per side. Other possible combinations include two headers 14 on one side and one on the other, or three on one side and none on the other, or any other combination of from zero to four headers 14 on each of the opposite sides of the tower 10 (as long as at least two headers 14 are included in the overall system).

Referring now to Figure 3, the respective feeder lines 16 are staggered so as not to duplicate coverage within the absorber tower 10. The opposite side of the absorber tower 10 (of which the headers 14 are not shown) contains essentially a similar arrangement to the illustrated side, but rotated through 180 degrees with the feeder lines 16 from all four headers 14 being at the same (or nearly the same) elevation within the absorber tower 10. In this interlocking and staggered fashion, the entire area within the absorber tower 10 may be covered by spray from the headers 14 and feeder lines 16 that are operating. In actuality, however, there is generally considerable overlapping of spray area such that any one complete header 14 and its respective feeder lines 16 could be removed from service and treated as the spare if need be without substantially affecting sulphur removal. That is, the spray from only three headers is required to achieve the desired sulphur removal so that any one of the four headers 14 can be out of service without substantially affecting operation. The headers 14 can be oriented in a manner such that they are fed from either end or any point along their length. Generally, the headers 14 are made larger at their feed point and become reduced in size as described earlier.

The spray configuration now disclosed can be used for any wet FGD system including dual alkali, magnesium promoted lime, magnesium promoted limestone, limestone, limestone forced oxidation, lime, sodium or the like. The advantage of the disclosed spray configuration is that tower height is reduced and overall power consumption is less than with those systems having multiple spray levels 12. Also, spare capacity is retained without the need for a separate spray level 12.

It should also be noted that each header 14 may typically be connected to its own pump (not shown) so as to be independent of each of the other headers 14. In this fashion, if it should be desirable to have spray coming from only two of the headers 14, the other two header pumps can be shut down without affecting the spray velocity or flow of the two headers 14 still in service. Additionally, if problems should occur in one of the systems, that system can be removed from service until the problem is solved without affecting the overall operation of the absorber tower 10. Also, since all the headers 14 are at the same (or substantially the same) elevation, less pumping power demand is required than in absorber towers having multiple spray levels. This is because with this system, each pump need only lift the mixture to one elevation, rather than to both that elevation and successively higher elevations as would be required for a tower with multiple spray levels.

Ideally, this system may be top supported or self supported so as to eliminate any wear occurring due to spray impingement, but it can also be bottom supported. Additionally, the materials used for construction (including materials for the nozzles) can be of any desired composition that is suitable for the environment within the absorber tower 10. The construction of the headers can be by any appropriate means including flanged, welded, glued, threaded or similar constructions. This system is also suitable for use with or without a gas distribution device, quench, presaturator, tray 22 or underspray assembly 18, the latter two components being shown in Figures 1 and 2. In the event that the underspray assembly 18 is used, spare capacity could be incorporated into the underspray assembly 18 in much the same manner as described above.

Referring now to Figures 6A to 6E, a number of possible configurations of the nozzles 20 are shown for use on the feeder lines 16. Figure 6A illustrates a single spiral type nozzle whilst Figure 6B shows a single straight nozzle. Figures 6C, 6D, and 6E respectively show double spiral (or straight) nozzles, double right angle nozzles with an eccentric connection to the feeder line 16, and double right angle nozzles tangentially connected to the feeder line 16. The number, type, and arrangement of the nozzles 20 is a function of the desired FGD design and desired spare capacity. Overall coverage is improved as the nozzles 20 are positioned closer to each other. In the embodiment shown, a spare capacity of 25% is achieved due to the locations of the feeder lines 16 and the nozzles 20. In some existing systems, it is not uncommon to have a total of about 250 nozzles per header thereby suggesting that there could be a total of about 1,000 nozzles in the entire system. These nozzles can be flanged, glued, welded, or screwed on to the feeder lines 16 as needed and can be oriented to spray upwards, downwards, or at any sideways angle.

It is also possible for the system to include internal headers rather than the external headers 14 as shown. As may be presumed, external headers have their manifolding outside the absorber tower 10 (as shown in Figure 3) whereas internal headers normally have only one absorber tower penetration with multiple branch lines within the absorber tower to ensure full coverage.

While it may appear from the plan view of Figure 3 that a major part of the entire area within the absorber tower 10 is blocked by the feeder lines 16, this is not the case. In reality, this symmetrical design configuration has a free passage open area of almost 50%. Additionally, if desired, it would be possible to construct an absorber tower 10 with two or three separate spray levels 12 as disclosed while still retaining the advantage of a shorter absorber tower and low power consumption compared to existing designs of a similar capacity. Spare capacity would be incorporated in either of the two or three separate spray levels while still maintaining overall coverage. In this case, the two or three separate spray levels can either be stacked above each other in alignment so as to appear exactly the same when viewed from the top or the spray levels can be angularly displaced at any angle appropriate for the arrangement. If spare capacity is incorporated into the underspray assembly 18 (if provided), typically it will have two supply headers 14 with one of these being a spare. The orientation of the underspray assembly 18 incorporating spare capacity can be independent of the orientation of the one to three separate spray levels 12.

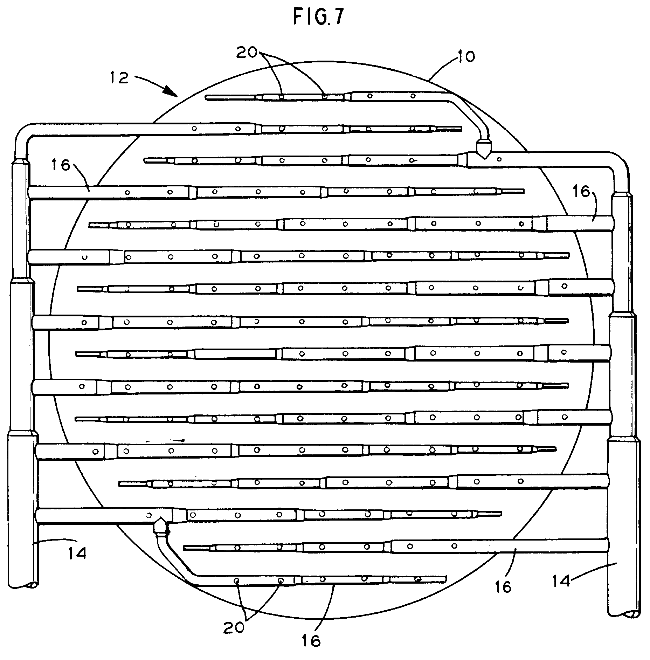

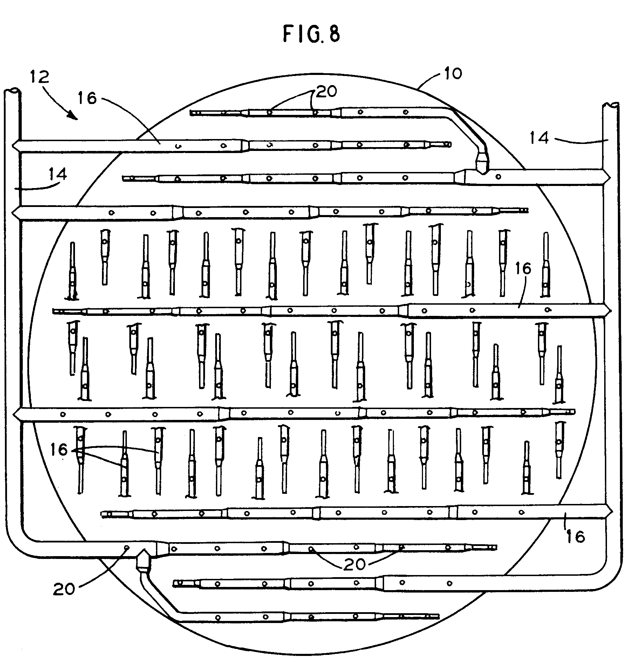

Referring now to Figures 7 and 8, each diagram shows a single spray level 12 of a different configuration to those described above. These spray levels 12 utilise only two headers 14 rather than the four shown in Figure 3. The feeder lines 16 are also configured differently. These and many other designs of spray level 12 are possible in accordance with embodiments of this invention, the two designs shown in Figures 7 and 8 merely being representative of the variations which are possible.

## Claims

1. Flue gas desulphurisation apparatus comprising:
a flue gas desulphurisation absorber tower (10);
at least two elongate headers (14) for supplying a liquid absorbent for the flue gas to the tower (10);
a plurality of elongate feeder lines (16) secured to each header (14) and extending within the tower (10) across the flue gas flow path therethrough in at least substantially the same plane; and
a plurality of nozzles (20) secured to each feeder line (16), the nozzles (20) being configured so as to spray the liquid absorbent on to the flue gas within the tower (10);
characterised in that the feeder lines (16) from the headers (14) are mutually staggered so as to extend in alternating interleaved manner across the flue gas path whereby adjacent feeder lines (16) in the substantially same plane are supplied by different headers (14).

2. Apparatus according to claim 1, including a respective pump assembly for supplying each header (14) with the liquid absorbent.

3. Apparatus according to claim 1 or claim 2, wherein each header (14) and its respective feeder lines (16) decrease in diameter along their length in the liquid absorbent flow direction.

4. Apparatus according to claim 1, claim 2 or claim 3, wherein at least one of the headers (14) is coplanar with the feeder line plane.

5. Apparatus according to claim 4, wherein two of the headers (14) are coplanar with the feeder line plane.

6. Apparatus according to any one of claims 1 to 5, wherein the headers (14) are located outside the tower (10).

7. Apparatus according to any one of the preceding claims, wherein at least two headers (14) are located on the same side of the tower (10).

8. Apparatus according to claim 7, wherein the headers (14) on the same side are offset vertically from each other.

9. Apparatus according to any one of the preceding claims, wherein the headers (14) are located on opposite sides of the tower (10).

10. Apparatus according to claim 9, wherein four headers (14) are provided, two each on opposite sides of the tower (10).

11. Apparatus according to claim 10, wherein at least two of the headers (14) located on opposite sides of the tower (10) are coplanar.

12. A method of spraying flue gas with a liquid absorbent in a flue gas desulphurisation absorber tower (10), the method comprising the steps of:
securing at least two elongate headers (14) to the tower (10) for supplying the liquid absorbent;
attaching multiple elongate feeder lines (16) to each header (14), the feeder lines (16) from each header (14) extending across the flue gas flow path in at least substantially the same plane within the tower (10);
securing a series of nozzles (20) to each feeder line (16) within the tower (10); and
spraying the liquid absorbent through the nozzles (20) on to the flue gas;
characterised in that the feeder lines (16) from the headers (14) are mutually staggered so as to extend in alternating interleaved manner across the flue gas path whereby the liquid absorbent in adjacent feeder lines (16) in the substantially same plane is supplied by different headers (14).

13. A method according to claim 12, wherein each header (14) is supplied with liquid absorbent from a respective pump assembly.

14. A method according to claim 12 or claim 13, wherein each header (14) and its respective feeder lines (16) decrease in diameter along their length in the liquid absorbent flow direction, so as to compensate for drop in fluid flow therealong.

15. A method according to any one of claims 12 to 14, wherein at least two headers (14) are located on the same side of the tower (10).

16. A method according to claim 15, wherein the headers (14) on the same side are offset vertically from each other.

17. A method according to any one of claims 12 to 16, wherein the headers (14) are located on opposite sides of the tower (10).

18. A method according to claim 17, wherein four headers (14) are provided, two each on opposite sides of the tower (10).

19. A method according to claim 18, wherein at least two of the headers (14) located on opposite sides of the tower (10) are coplanar.

## Patentansprüche

1. Vorrichtung zur Rauchgasentschwefelung mit
einem Rauchgasentschwefelungs-Absorberturm (10),
wenigstens zwei länglichen Verteilern (14) für die Zufuhr eines flüssigen Absorbens für das Rauchgas in dem Turm (10),
mehreren länglichen Zubringerleitungen (16), die an jedem Verteiler (14) befestigt sind und sich in dem Turm (10) über den Rauchgasströmungsweg in wenigstens im wesentlichen der gleichen Ebene erstrecken, und
mehreren Düsen (20), die an jeder Zubringerleitung (16) befestigt sind, wobei die Düsen (20) so gestaltet sind, daß sie das flüssige Absorbens auf das Rauchgas in dem Turm (10) sprühen,
**dadurch gekennzeichnet**, daß die Zubringerleitungen (16) von den Verteilern (14) wechselseitig derart gestaffelt sind, daß sie sich in alternierend verzahnter Weise quer über den Abgasweg erstrecken, wobei einander benachbarte Zubringerleitungen (16) in der im wesentlichen gleichen Ebene von unterschiedlichen Verteilern (14) ausgehen.

2. Vorrichtung nach Anspruch 1 mit jeweils einer Pumpanordnung für Versorgung jedes Verteilers (14) mit dem flüssigen Absorbens.

3. Vorrichtung nach Anspruch 1 oder Anspruch 2, bei der jeder Verteiler (14) und seine jeweiligen Zubringerleitungen (16) im Durchmesser entlang ihrer Länge in der Flüssigkeitsabsorbensfließrichtung abnehmen.

4. Vorrichtung nach Anspruch 1, Anspruch 2 oder Anspruch 3, bei der wenigstens einer der Verteiler (14) in der gleichen Ebene mit der Zubringerleitungsebene liegt.

5. Vorrichtung nach Anspruch 4, bei der zwei der Verteiler (14) in der gleichen Ebene wie die Zubringerleitungsebene liegen.

6. Vorrichtung nach einem der Ansprüche 1 bis 5, bei der die Verteiler (14) außerhalb des Turmes (10) angeordnet sind.

7. Vorrichtung nach einem der vorausgehenden Ansprüche, bei der wenigstens zwei Verteiler (14) auf der gleichen Seite des Turmes (10) angeordnet sind.

8. Vorrichtung nach Anspruch 7, bei der die Verteiler (14) auf der gleichen Seite vertikal gegeneinander versetzt angeordnet sind.

9. Vorrichtung nach einem der vorausgehenden Ansprüche, bei der die Verteiler (14) auf gegenüberliegenden Seiten des Turmes (10) angeordnet sind.

10. Vorrichtung nach Anspruch 9, bei der vier Verteiler (14) vorgesehen sind, jeweils zwei auf gegenüberliegenden Seiten des Turmes (10).

11. Vorrichtung nach Anspruch 10, bei der wenigstens zwei der Verteiler (14), die auf gegenüberliegenden Seiten des Turmes (10) angeordnet sind, in einer Ebene liegen.

12. Verfahren zum Besprühen von Rauchgas mit einem flüssigen Absorbens in einem Rauchgasentschwefelungs-Absorberturm (10) mit den Stufen, in denen man
wenigstens zwei längliche Verteiler (14) an dem Turm (10) für die Zufuhr des flüssigen Absorbens befestigt,
mehrere längliche Zubringerleitungen (16) an jedem Verteiler (14) befestigt, wobei sich die Zubringerleitungen (16) von jedem Verteiler (14) über den Rauchgasströmungsweg in wenigstens im wesentlichen der gleichen Ebene in dem Turm (10) erstrecken,
eine Reihe von Düsen (20) an jeder Zubringerleitung (16) in dem Turm (10) befestigt und
das flüssige Absorbens durch die Düsen (20) auf das Rauchgas aufsprüht,
**dadurch gekennzeichnet**, daß die Zubringerleitungen (16) von den Verteilern (14) wechselseitig derart versetzt sind, daß sie sich in alternierend verzahnter Weise über den Rauchgasweg erstrecken, wobei das flüssige Absorbens in benachbarten Zubringerleitungen (16) in der im wesentlichen gleichen Ebene durch unterschiedliche Verteiler (14) zugeführt wird.

13. Verfahren nach Anspruch 12, bei dem jeder Verteiler (14) mit flüssigem Absorbens aus einer betreffenden Pumpanordnung versorgt wird.

14. Verfahren nach Anspruch 12 oder Anspruch 13, bei dem jeder Verteiler (14) und seine jeweiligen Zubringerleitungen (16) im Durchmesser entlang ihrer Länge in der Fließrichtung des flüssigen Absorbens abnehmen, um so die Abnahme des Fluidflusses entlang ihnen zu kompensieren.

15. Verfahren nach einem der Ansprüche 12 bis 14, bei dem wenigstens zwei Verteiler (14) auf der gleichen Seite des Turmes (10) angeordnet sind.

16. Verfahren nach Anspruch 15, bei dem die Verteiler (14) auf der gleichen Seite vertikal gegeneinander versetzt sind.

17. Verfahren nach einem der Ansprüche 12 bis 16, bei dem die Verteiler (14) auf einander gegenüberliegenden Seiten des Turmes (10) angeordnet sind.

18. Verfahren nach Anspruch 17, bei dem vier Verteiler (14) vorgesehen sind, jeweils zwei auf einander gegenüberliegenden Seiten des Turmes (10).

19. Verfahren nach Anspruch 18, bei dem wenigstens zwei der Verteiler (14), die aufeinander gegenüberliegenden Seiten des Turmes (10) angeordnet sind, in einer Ebene liegen.

## Revendications

1. Appareil de désulfuration des gaz de fumées comprenant :
une tour d'absorption de désulfuration des gaz de fumées (10) ;
au moins deux têtes allongées (14) destinées à fournir à la tour d'absorption (10) un produit absorbant liquide des gaz de fumées ;
une multitude de conduites d'alimentation allongées (16) fixées à chaque tête (14) s'étendant à l'intérieur de la tour (10) en travers de toute la trajectoire du flux de gaz de fumées selon un plan au moins substantiellement identique ; et
une multitude de gicleurs (20) fixés à chaque conduite d'alimentation (16), les gicleurs (20) étant configurés de telle sorte qu'ils pulvérisent le produit absorbant liquide sur les gaz de fumées à l'intérieur de la tour (10) ;
caractérisé en ce que les conduites d'alimentation (16) partant des têtes (14) sont mutuellement imbriquées en quinconce de façon à s'étendre de manière à former des espaces alternés en travers de la trajectoire des gaz de fumées, des conduites d'alimentation (16) adjacentes étant de ce fait fournies par différentes têtes (14) selon un plan substantiellement identique.

2. Appareil selon la Revendication 1, comprenant un ensemble de pompage respectif destiné à alimenter chaque tête (14) en produit absorbant liquide.

3. Appareil selon la Revendication 1 ou la Revendication 2, dans lequel chaque tête (14) et ses conduites d'alimentation respectives (16) présentent un diamètre allant se rétrécissant tout au long de leur longueur dans le sens du flux de produit absorbant liquide.

4. Appareil selon la Revendication 1, la Revendication 2 ou la Revendication 3, dans lequel au moins l'une des têtes (14) est coplanaire avec le plan de la conduite d'alimentation.

5. Appareil selon la Revendication 4, dans lequel deux des têtes (14) sont coplanaires avec le plan de la conduite d'alimentation.

6. Appareil selon l'une quelconque des Revendications 1 à 5 dans lequel les têtes (14) sont situées à l'extérieur de la tour (10).

7. Appareil selon l'une quelconque des Revendications précédentes, dans lequel au moins deux têtes (14) sont situées sur le même côté de la tour (10).

8. Appareil selon la Revendication 7, dans lequel les têtes (14) disposées du même côté sont décalées verticalement l'une par rapport à l'autre.

9. Appareil selon l'une quelconque des Revendications précédentes, dans lequel les têtes (14) sont situées sur des côtés opposés de la tour (10).

10. Appareil selon la Revendication 9, dans lequel quatre têtes (14) sont fournies, dont deux d'entre elles sur des côtés opposés de la tour (10).

11. Appareil selon la Revendication 10, dans lequel au moins deux des têtes (14) situées sur des côtés opposés de la tour (10) sont coplanaires.

12. Une méthode de pulvérisation des gaz de fumées à l'aide d'un produit absorbant liquide dans une tour d'absorption (10) de désulfuration des gaz de fumées, la méthode comprenant les étapes consistant à :
fixer à la tour (10) au moins deux têtes allongées (14), destinées à fournir le produit absorbant liquide ;
attacher à chaque tête (14) des conduites d'alimentation allongées multiples (16), les conduites d'alimentation (16) partant de chaque tête (14) s'étendant en travers de la trajectoire de flux des gaz de fumées selon un plan au moins substantiellement identique à l'intérieur de la tour (10) ;
fixer à chaque conduite d'alimentation (16) une série de gicleurs (20) à l'intérieur de la tour (10); et
pulvériser le produit absorbant liquide à travers les gicleurs (20) sur les gaz de fumées ;
caractérisée en ce que les conduites d'alimentation (16) partant des têtes (14) sont mutuellement imbriquées en quinconce de façon à s'étendre de manière à former des espaces alternés en travers de la trajectoire des gaz de fumées, le produit absorbant liquide présent dans les conduites d'alimentation adjacentes (16) étant de ce fait fourni par différentes têtes (14) selon un plan substantiellement identique.

13. Une méthode selon la Revendication 12, dans laquelle chaque tête (14) est alimentée en produit absorbant liquide depuis un ensemble de pompage respectif.

14. Une méthode selon la Revendication 12 ou la Revendication 13, dans laquelle chaque tête (14) et ses conduites d'alimentation respectives (16) présentent un diamètre allant se rétrécissant tout au long de leur longueur dans le sens du flux de produit absorbant liquide, de façon à compenser la baisse du flux de fluide dans celles-ci.

15. Une méthode selon l'une quelconque des Revendications 12 à 14, dans laquelle au moins deux têtes (14) sont situées du même côté de la tour (10).

16. Une méthode selon la Revendication 15, dans laquelle les têtes (14) disposées du même côté sont décalées verticalement les unes par rapport aux autres.

17. Une méthode selon l'une quelconque des Revendications 12 à 16, dans laquelle les têtes (14) sont situées sur des côtés opposés de la tour (10).

18. Une méthode selon la Revendication 17, dans laquelle les quatre têtes (14) sont fournies, dont deux d'entre elles sur des côtés opposés de la tour (10).

19. Une méthode selon la Revendication 18, dans laquelle au moins deux des têtes (14) situées sur des côtés opposés de la tour (10) sont coplanaires.
